# EUROPEAN PATENT APPLICATION

(11) **EP 4 815 680 A1**
(43) Date of publication of application: **30.09.2026**
(21) Application number: 25214331.8
(22) Date of filing: 07.11.2025
(51) Int. Cl.: H10F 19/90, H10F 77/20

(54) **BACK CONTACT CELL AND PHOTOVOLTAIC MODULE**

(30) Priority: 28.03.2025 CN 202510386922; 28.03.2025 CN 202520574421 U
(71) Applicant: Jinko Solar Co., Ltd., Shangrao, Jiangxi (CN); Jinko Solar (Haining) Co., Ltd., Haining City, Zhejiang 314415 (CN)
(72) Inventor: TAO, Wusong, Shangrao, Jiangxi 334100 (CN); XU, Tao, Shangrao, Jiangxi 334100 (CN); WANG, Luchuang, Shangrao, Jiangxi 334100 (CN)
(74) Representative: Balder IP Law, S.L.

(57) **Abstract**

A back contact cell includes: a substrate having a first edge; first and second doped conductive layers alternately distributed on the second surface; first grid lines and second grid lines alternately arranged along a first direction; first and second connection lines alternately arranged along a second direction, wherein a respective first connection line is electrically connected to a respective set of the first grid lines including edge connection lines and intermediate connection lines, the edge connection lines have no welding portions, a second connection line adjacent to the edge connection lines includes a plurality of functional portions spaced apart from each other; a connection structure having a first end electrically connected to an edge connection line.

## Description

### TECHNICAL FIELD

Embodiments of the present disclosure relate to the photovoltaic field, and particularly to a back contact cell and a photovoltaic module.

### BACKGROUND

Currently, with the gradual depletion of fossil energy, solar cells, as a new energy alternative, are being used more and more widely. Solar cells are devices that convert solar light energy into electrical energy. Solar cells utilize the photovoltaic principle to generate carriers, and then use electrodes to extract the carriers, thereby facilitating the effective utilization of electrical energy.

Current photovoltaic cells mainly include BC (back contact) cells, TOPCON (Tunnel Oxide Passivated Contact) cells, PERC cells (Passivated Emitter and Rear Cell), and heterojunction cells, and the like.

However, edges of back contact cells in related technologies carry a risk of cracking, resulting in a lower yield rate for photovoltaic modules.

### SUMMARY

Embodiments of the present disclosure provide a back contact cell and a photovoltaic module, which at least improve a performance of the back contact cell and a yield rate of the photovoltaic module.

According to some embodiments of the present disclosure, one aspect of the embodiments of the present disclosure provides a back contact cell, including: a substrate, the substrate having a first surface and a second surface opposite to each other, the second surface having a first edge; a first doped conductive layer and a second doped conductive layer, portions of the first doped conductive layer and portions of the second doped conductive layer alternately distributed across the second surface, doping elements in the first doped conductive layer being of a first conductivity type and doping elements in the second doped conductive layer being of a second conductivity type that is different from the first conductive type; first grid lines and second grid lines alternately arranged along a first direction, at least a portion of the first grid lines being in electrical contact with the first doped conductive layer, at least a portion of the second grid lines being in electrical contact with the second doped conductive layer; first connection lines and second connection lines alternately arranged along a second direction, a respective first connection line of the first connection lines being electrically connected to a respective set of the first grid lines, the first connection lines including edge connection lines and intermediate connection lines, the edge connection lines having no welding portions provided thereon, the second connection lines including a second connection line adjacent to the edge connection lines and comprising a plurality of functional portions spaced apart from each other in the first direction a respective functional portion of the plurality of functional portions being connected to a respective set of a plurality of sets of the second grid lines; a connection structure having a first end electrically connected to an edge connection lines, the connection structure extending from the first end in the second direction and passing through a space between two adjacent functional portions to be electrically connected to the intermediate connection lines adjacent to the edge connection line; wherein, a first grid line of the respective set of the first grid lines comprises two first main body portions and a first connection portion between and connecting the two first main body portions, the first connection portion not being in electrical contact with the first doped conductive layer; a second grid line of the second grid lines comprises two second main body portions and a second connection portion between and connecting the two second main body portions, the second connection portion not being in electrical contact with the second doped conductive layer.

In some embodiments, the functional portion includes a first part adjacent to the connection structure and a second part connected to the first part; along the second direction, a width of the first part is greater than a width of the second part.

In some embodiments, along the second direction, the width of the first part is 0.02mm~0.1mm, and the width of the second part is 0.01mm~0.05mm.

In some embodiments, along the first direction, the first connection portion is electrically connected to the first connection lines, the second connection portion is electrically connected to the second connection lines, a width of the first connection portion is greater than a width of the first main body portion, and a width of the second connection portion is greater than a width of the second main body portion.

In some embodiments, along the first direction, the width of the first connection portion is 0.02mm~0.1mm, the width of the first main body portion is 0.01mm~0.05mm, the width of the second connection portion is 0.02mm~0.1mm, and the width of the second main body portion is 0.01mm~0.05mm.

In some embodiments, along the second direction, a distance between the edge connection lines and the second connection lines adjacent to the edge connection lines is a first spacing, and a distance between the second connection lines adjacent to the edge connection lines and the intermediate connection lines which is adjacent to the second connection lines adjacent to the edge connection lines is a second spacing, the first spacing being less than the second spacing.

In some embodiments, the first spacing is 0.5mm~1.5mm, and the second spacing is 0.7mm~2.0mm.

In some embodiments, the back contact cell further includes: first pads, the first pads located at an intersection of a portion of the first connection lines and the first grid lines, and electrically connected to the first connection lines and the first grid lines; second pads, the second pads located at an intersection of a portion of the second connection lines and the second grid lines, and electrically connected to the second connection lines and the second grid lines; the second surface further includes a third edge connected to the first edge; along the first direction, the first pads adjacent to the third edge is spaced apart from the first grid lines adjacent to the third edge, and the second pads adjacent to the third edge is spaced apart from the first grid lines adjacent to the third edge.

In some embodiments, along the first direction, a distance between the first pads adjacent to the third edge and the first grid lines adjacent to the third edge is 5mm~15mm, and a distance between the second pads adjacent to the third edge and the first grid lines adjacent to the third edge is 5mm~15mm.

According to some embodiments of the present disclosure, another aspect of the embodiments of the present disclosure further provides a photovoltaic module, including: a cell string, formed by connecting a plurality of back contact cells according to any of the preceding embodiments; ribbons, the ribbons used for connecting adjacent back contact cells; an encapsulant film, used for covering a surface of the cell string; a cover plate, used for covering a surface of the encapsulant film opposite to the cell string.

The technical solutions provided by the embodiments of the present disclosure at least have the following advantages.

In the above-described back contact cell, the connection structure has a first end electrically connected to an edge connection line, the connection structure extends from the first end in the second direction and passing through a space between two adjacent functional portions to be electrically connected to the intermediate connection lines adjacent to the edge connection line. Through the connection structure, the intermediate connection lines adjacent to the edge connection lines collects the current collected by the edge connection lines, thereby allowing the edge connection lines to have no welding portion. This can avoid a problem of cracking or micro-cracking at the edge of the back contact cell due to soldering stress, thus improving the yield rate of the photovoltaic module.

Furthermore, a first grid line of the respective set of the first grid lines includes two first main body portions and a first connection portion between and connecting the two first main body portions, and the first connection portion is not in electrical contact with the first doped conductive layer, resulting in a smaller contact area between the first grid lines and the first doped conductive layer, thereby reducing metal recombination between the first grid lines and the first doped conductive layer, and thus improving the performance of the back contact cell. Moreover, a second grid line of the second grid lines includes two second main body portions and a second connection portion between and connecting the two second main body portions, and the second connection portion is not in electrical contact with the second doped conductive layer, resulting in a smaller contact area between the second grid lines and the second doped conductive layer, thereby reducing metal recombination between the second grid lines and the second doped conductive layer, and thus improving the performance of the back contact cell.

### BRIEF DESCRIPTION OF THE DRAWINGS

One or more embodiments are exemplarily illustrated by the figures in the corresponding drawings. These exemplary illustrations do not limit the embodiments, and unless otherwise stated, the drawings are not to scale. To describe the technical solutions in the embodiments of the present disclosure or in the prior art more clearly, the following briefly introduces the accompanying drawings required for describing the embodiments. Obviously, the accompanying drawings in the following description show only some embodiments of the present disclosure, and a person of ordinary skill in the art may still derive other drawings from these accompanying drawings without creative efforts.
FIG. 1 is a cross-sectional view of a back contact cell according to an embodiment of the present disclosure;
FIG. 2 is a first schematic structural diagram of a back contact cell according to an embodiment of the present disclosure;
FIG. 3 is a partial enlarged schematic view of portion A in FIG. 2;
FIG. 4 is a second schematic structural diagram of a back contact cell according to an embodiment of the present disclosure;
FIG. 5 is a third schematic structural diagram of a back contact cell according to an embodiment of the present disclosure;
FIG. 6 is a partial enlarged schematic view of portion B in FIG. 5;
FIG. 7 is a fourth schematic structural diagram of a back contact cell according to an embodiment of the present disclosure;
FIG. 8 is a partial enlarged schematic view of portion C in FIG. 7;
FIG. 9 is a fifth schematic structural diagram of a back contact cell according to an embodiment of the present disclosure;
FIG. 10 is a cross-sectional view of a photovoltaic module according to an embodiment of the present disclosure.

### DETAILED DESCRIPTION OF THE EMBODIMENTS

In back contact cells in related technologies, pads and ribbons are provided on the grid lines at the cell edge. The ribbons electrically connect multiple back contact cells to form a cell string within a photovoltaic module. However, during the process of soldering pads and ribbons onto the grid lines at the edge of the back contact cell, stress tends to be highly concentrated at the edge of the back contact cell, which can easily cause the back contact cell to crack, resulting in a lower yield rate of the photovoltaic module.

Therefore, the yield rate of photovoltaic modules in related technologies needs improvement.

In the back contact cell provided by the embodiments of the present disclosure,the connection structure has a first end electrically connected to an edge connection line, the connection structure extends from the first end in the second direction and passing through a space between two adjacent functional portions to be electrically connected to the intermediate connection lines adjacent to the edge connection line. Through the connection structure, the intermediate connection lines adjacent to the edge connection lines collects the current collected by the edge connection lines, thereby allowing the edge connection lines to have no welding portion (such as solder joints or pads). This can avoid the problem of cracking or micro-cracking at the edge of the back contact cell due to soldering stress, thus improving the yield rate of the photovoltaic module.

On one hand, a first grid line of the respective set of the first grid lines includes two first main body portions and a first connection portion between and connecting the two first main body portions, and the first connection portion is not in electrical contact with the first doped conductive layer, resulting in a smaller contact area between the first grid lines and the first doped conductive layer, thereby reducing metal recombination between the first grid lines and the first doped conductive layer. On the other hand, a second grid line of the second grid lines includes two second main body portions and a second connection portion between and connecting the two second main body portions, and the second connection portion is not in electrical contact with the second doped conductive layer, resulting in a smaller contact area between the second grid lines and the second doped conductive layer, thereby reducing metal recombination between the second grid lines and the second doped conductive layer. Both aspects are beneficial for improving the performance of the back contact cell.

In the description of the embodiments of the present disclosure, technical terms such as "first," "second," and the like, are used only to distinguish different objects and should not be construed as indicating or implying relative importance or implicitly specifying the quantity, a specific order, or a primary-secondary relationship of the indicated technical features. In the description of the embodiments of the present disclosure, "a plurality of" means two or more, unless otherwise explicitly and specifically defined.

Mention of "embodiment" in this document means that specific features, structures, or characteristics described in connection with the embodiment may be included in at least one embodiment of the present disclosure. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein can be combined with other embodiments.

In the description of the embodiments of the present disclosure, the term "and/or" merely describes an associative relationship between associated objects, indicating that three relationships may exist. For example, A and/or B may indicate: existence of A alone, simultaneous existence of A and B, and existence of B alone. Furthermore, the character "/" in this text generally indicates that the associated objects are in an "or" relationship.

In the description of the embodiments of the present disclosure, the term "a plurality of' refers to two or more (including two). Similarly, "a plurality of groups" refers to two or more groups (including two groups), and "a plurality of pieces" refers to two or more pieces (including two pieces).

In the description of the embodiments of the present disclosure, technical terms indicating orientation or positional relationships such as "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," and the like, are based on the orientation or positional relationships shown in the accompanying drawings. They are used only to facilitate the description of the embodiments of the present disclosure and simplify the description, rather than indicating or implying that the referred device or element must have a specific orientation or be constructed and operated in a specific orientation. Therefore, they should not be construed as limitations on the embodiments of the present disclosure.

In the description of the embodiments of the present disclosure, unless otherwise explicitly specified and defined, technical terms such as "install," "connect," "link," "fix," and the like, should be interpreted broadly. For example, they may refer to a fixed connection, a detachable connection, or integration into one piece; they may also refer to a mechanical connection, an electrical connection, or direct connection, or indirect connection through an intermediate medium, or internal communication between two elements or interaction between two elements. Those of ordinary skill in the art can understand the specific meanings of these terms in the embodiments of the present disclosure based on the specific context.

In the drawings corresponding to the embodiments of the present disclosure, for better understanding and ease of description, thicknesses and areas of layers are exaggerated. When describing that a component (such as a layer, a film, a region, or a substrate) is located on or on the surface of another component, it can be "directly" on the surface of another component, or there may be a third component between the two components. Conversely, when describing that a component is on the surface of another component, or that another component is formed or provided on the surface of a component, it means that there is no third component between the two components. Furthermore, when describing that a component is "substantially" formed on another component, it means that the component is not formed on the entire surface (or front surface) of another component, nor is it formed on part of the edge of the entire surface.

In the description of the embodiments of the present disclosure, when a component "includes" another component, unless otherwise specified, it does not exclude other components, and other components may also be included. Furthermore, when a component such as a layer, a film, a region, or a plate is described as being "on/located on" another component, it can be "directly on" another component (i.e., located on the surface of another component with no other component in between), or there may be another component in between. Furthermore, when a component such as a layer, film, region, or plate is "directly located on" another component, or when a component such as a layer, a film, a region, or a plate is located on the surface of another component, it means that no other component is located in between.

The embodiments of the present disclosure will be described in detail below with reference to the accompanying drawings. However, those of ordinary skill in the art can understand that in the various embodiments of the present disclosure, many technical details are proposed to enable the reader to better understand the present disclosure. However, even without these technical details and various changes and modifications based on the following embodiments, the technical solutions claimed in the present disclosure can be implemented.

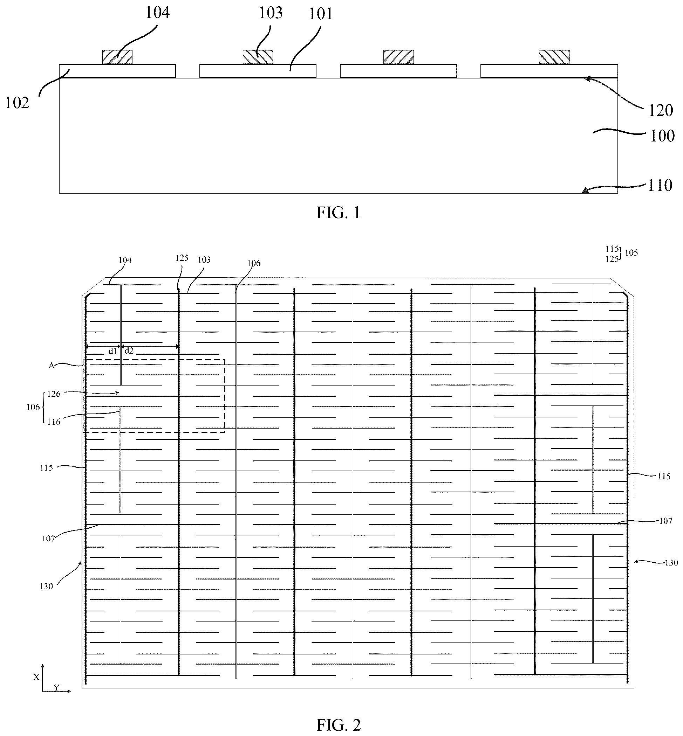

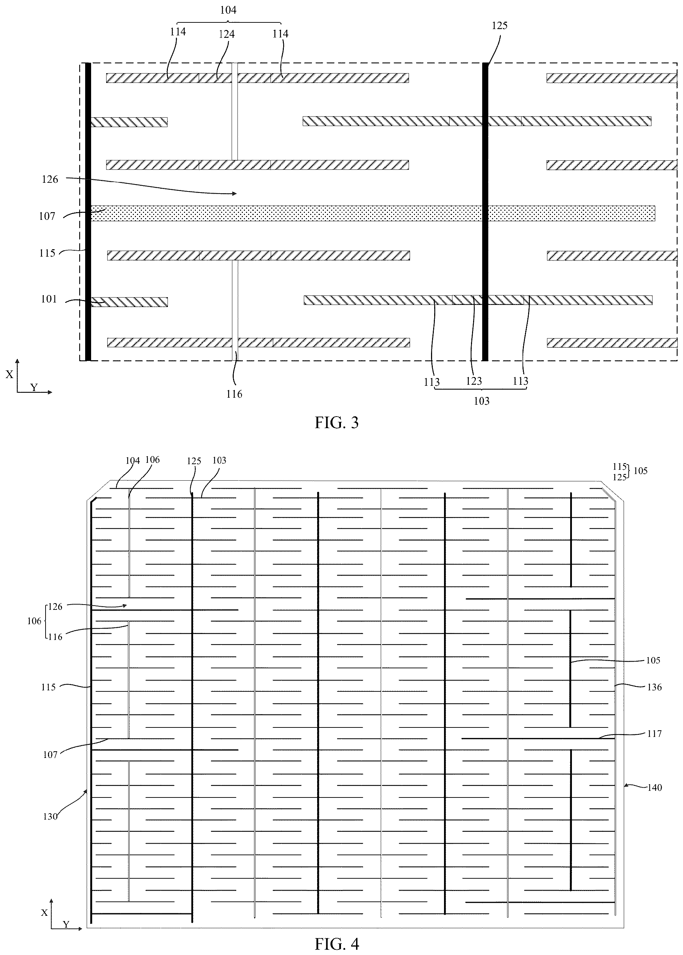

FIG. 1 is a cross-sectional view of a back contact cell provided by an embodiment of the present disclosure; FIG. 2 is a first schematic structural diagram of a back contact cell provided by an embodiment of the present disclosure; FIG. 3 is a partial enlarged schematic view of portion A in FIG. 2.

Referring collectively to FIG. 1 to FIG. 3, the back contact cell includes: a substrate 100, the substrate 100 has a first surface 110 and a second surface 120 opposite to each other, the second surface 120 has a first edge 130; a first doped conductive layer 101 and a second doped conductive layer 102, portions of the first doped conductive layer 101 and portions of the second doped conductive layer 102 are alternately distributed across the second surface 120, doping elements in the first doped conductive layer 101 are of a first conductive type, and doping elements in the second doped conductive layer 102 are of a second conductive type that is different from the first conductivity type; first grid lines 103 and second grid lines 104 alternately arranged along a first direction X, at least a portion of the first grid lines 103 are in electrical contact with the first doped conductive layer 101, at least a portion of the second grid lines 104 are in electrical contact with the second doped conductive layer 102; first connection lines 105 and second connection lines 106 alternately arranged along a second direction Y, a respective first connection line of the first connection lines 105 is electrically connected to a respective set of the first grid lines 103, the first connection lines 105 include edge connection lines 115 and intermediate connection lines 125, the edge connection lines 115 have no welding portions provided thereon, the second connection lines 106 including a second connection line 106 adjacent to the edge connection lines 115 and comprising a plurality of functional portions 116 spaced apart from each other in the first direction, a respective functional portion of the plurality of functional portions 116 being connected to a respective set of a plurality of sets of the second grid lines 106; a connection structure 107 having a first end electrically connected to an edge connection line 115, the connection structure extending from the first end in the second direction and passing through a space between two adjacent functional portions to be electrically connected to the intermediate connection lines 125 adjacent to the edge connection line 115; wherein, a first grid line of the respective set of the first grid lines 103 comprises two first main body portions 113 and a first connection portion 123 between and connecting the two first main body portions 113, the first connection portion 123 not being in electrical contact with the first doped conductive layer 101; a second grid line of the second grid lines 104 comprises two second main body portions 114 and a second connection portion 124 between and connecting the two second main body portions 114, the second connection portion 124 not being in electrical contact with the second doped conductive layer 102.

The back contact cell is used for absorbing sunlight and converting light energy into electrical energy.

The substrate 100 is used for receiving incident light and generating photogenerated carriers. In some embodiments, the substrate 100 can be a semiconductor substrate.

In some embodiments, a material of the substrate 100 can be an elemental semiconductor material. Specifically, the elemental semiconductor material consists of a single element, for example, it can be silicon or germanium. The elemental semiconductor material can be in a single crystal state, polycrystalline state, amorphous state, or microcrystalline state (a state simultaneously having single crystal and amorphous states is called microcrystalline state). For example, silicon can be single crystal silicon, polycrystalline silicon, amorphous silicon, or microcrystalline silicon, or at least one of them.

In some embodiments, the material of the substrate 100 can also be a compound semiconductor material. Common compound semiconductor materials include, but are not limited to, silicon germanium, silicon carbide, gallium arsenide, indium gallium, perovskite, cadmium telluride, copper indium selenide, and other materials.

The substrate 100 can also be a sapphire substrate, a silicon-on-insulator substrate, or a germanium-on-insulator substrate.

The substrate 100 can be an N-type semiconductor substrate or a P-type semiconductor substrate. The N-type semiconductor substrate is doped with N-type doping elements. The N-type doping elements can be any one of Group V elements such as phosphorus (P), bismuth (Bi), antimony (Sb), or arsenic (As). The P-type semiconductor substrate is doped with P-type elements. The P-type doping elements can be any one of Group III elements such as boron (B), aluminum (Al), gallium (Ga), or indium (In).

The substrate 100 has a first surface 110 and a second surface 120 opposite to each other.

In some embodiments, the back contact cell is a single-sided cell, then the first surface 110 of the substrate 100 can serve as the light-receiving surface for receiving incident light, and the second surface 120 serves as the back surface. In some embodiments, the back contact cell is a double-sided cell, then both the first surface 110 and the second surface 120 of the substrate 100 can serve as light-receiving surfaces, both can be used for receiving incident light. It can be understood that the back surface referred to in the embodiments of this application can also receive incident light, but the degree of reception of incident light is weaker than that of the light-receiving surface, thus it is defined as the back surface.

In some embodiments, a texturing process can be performed on at least one of the first surface or the second surface of the substrate to form a textured surface on at least one of the first surface or the second surface of the substrate. This can enhance the absorption and utilization of incident light by the first surface and the second surface of the substrate.

In some embodiments, the textured surface can be a pyramid textured surface. As a common textured surface, the pyramid textured surface not only reduces the reflectivity of the substrate surface but also forms a light trap, enhancing an absorption of incident light by the substrate and improving the photoelectric conversion efficiency of the back contact cell.

Specifically, if the back contact cell is a single-sided cell, a textured surface, such as a pyramid textured surface, can be formed on the light-receiving surface of the substrate. The back surface of the substrate can be a polished surface, i.e., the back surface of the substrate is flatter compared to the light-receiving surface. It should be noted that for a single-sided cell, textured surfaces can also be formed on both the light-receiving surface and the back surface of the substrate.

If the back contact cell is a double-sided cell, textured surfaces can be formed on both the light-receiving surface and the back surface of the substrate.

The first doped conductive layer 101 is doped with one of P-type elements and N-type elements, and the second doped conductive layer 102 is doped with the other of P-type elements and N-type elements.

In some embodiments, the substrate 100 is an N-type substrate, then the doping concentration of the N-type doping elements in the first doped conductive layer 101 or the second doped conductive layer 102 is greater than the doping concentration of the doping elements in the substrate 100. The first doped conductive layer 101 or the second doped conductive layer 102 and the substrate 100 form a high-low junction, enhancing the carrier separation capability. In some embodiments, the substrate 100 is a P-type substrate, then the doping concentration of the P-type doping elements in the first doped conductive layer 101 or the second doped conductive layer 102 is greater than the doping concentration of the doping elements in the substrate 100. The first doped conductive layer 101 or the second doped conductive layer 102 and the substrate 100 form a high-low junction, enhancing the carrier separation capability.

A gap or an isolation structure may be provided between the first doped conductive layer 101 and the second doped conductive layer 102 to achieve automatic isolation between regions of different conductivity types. This can prevent the formation of a tunnel junction between the first doped conductive layer 101 and the second doped conductive layer 102 which are on the second surface 120, which could cause leakage current and affect cell efficiency.

At least a portion of the first grid lines 103 are in electrical contact with the first doped conductive layer 101, and at least a portion of the second grid lines 104 are in electrical contact with the second doped conductive layer 102. The first grid lines 103 and the second grid lines 104 are used to collect the current of the back contact cell.

The first connection lines 105 are in electrical contact with the first grid lines 103 and are used to collect the current from the first grid lines 103.

The second connection lines 106 are in electrical contact with the second grid lines 104 and are used to collect the current from the second grid lines 104.

The first connection lines 105 are not in electrical contact with the first doped conductive layer 101, and the second connection lines 106 are not in electrical contact with the second doped conductive layer 102.

In some embodiments, the connection structure 107 can be in electrical contact with the first doped conductive layer 101. In this way, the connection structure 107 cannot only achieve current continuity between the edge connection line 115 and the adjacent intermediate connection line 125, but the connection structure 107 can also itself collect current from the surface of the substrate 100, thereby increasing the collection path and improving the efficiency of current collection.

In some embodiments, the connection structure 107 may not be in electrical contact with the first doped conductive layer 101. This can avoid the metal recombination problem caused by the electrical contact between the connection structure 107 and the first doped conductive layer 101, thereby improving the performance of the back contact cell.

In some embodiments, the back contact cell may further include a passivation layer (not shown). The passivation layer is located on the surface of the first doped conductive layer 101 and the second doped conductive layer 102 facing away from the second surface 120. The passivation layer may include a single-layer film structure or a laminated film structure. The material of the passivation layer may include any one or more of silicon oxide, silicon nitride, silicon oxynitride, carbon silicon oxynitride, titanium oxide, hafnium oxide, or aluminum oxide, and the like.

The first main body portions 113 of the first grid lines 103 are in electrical contact with the first doped conductive layer 101. This can mean that the first main body portions 113 penetrate the passivation layer to be in electrical contact with the first doped conductive layer 101. The first connection portion 123 is not in electrical contact with the first doped conductive layer 101. This can mean that at most part of the first connection portion 123 is embedded in the passivation layer without penetrating the passivation layer, and thus is not in electrical contact with the first doped conductive layer 101. The first connection lines 105 are not in electrical contact with the first doped conductive layer 101. This can mean that at most part of the first connection lines 105 are embedded in the passivation layer without penetrating the passivation layer, and thus are not in electrical contact with the first doped conductive layer 101.

The second main body portions 114 of the second grid lines 104 are in electrical contact with the second doped conductive layer 102. This can mean that the second main body portions 114 penetrate the passivation layer to be in electrical contact with the second doped conductive layer 102. The second connection portion 124 is not in electrical contact with the second doped conductive layer 102. This can mean that at most part of the second connection portion 124 is embedded in the passivation layer without penetrating the passivation layer, and thus is not in electrical contact with the second doped conductive layer 102. The second connection lines 106 are not in electrical contact with the second doped conductive layer 102. This can mean that at most part of the second connection lines 106 are embedded in the passivation layer without penetrating it, and thus are not in electrical contact with the second doped conductive layer 102.

In some embodiments, if the total number of the first connection lines 105 and the second connection lines 106 is odd, referring to FIG. 1 and FIG. 2, the second surface 120 has two first edges 130 opposite to each other. The conductivity type of the edge connection line 115 corresponding to the first edge 130 of the substrate 100 is the same as the conductivity type of the first connection lines 105.

FIG. 4 is a second schematic structural diagram of a back contact cell provided by an embodiment of the present disclosure.

In other embodiments, if the total number of first connection lines 105 and second connection lines 106 is even, referring to FIG. 1 and FIG. 4, the second surface 120 has a second edge 140 opposite to the first edge 130. The conductivity type of the second edge connection line 136 corresponding to the second edge 140, the conductivity type of the second connection structure 117, and the conductivity type of the second connection lines 106 are all the same. Then, the first connection line 105 adjacent to the second edge connection line 136 also needs to be designed as described above for the corresponding second connection line 106. That is, the second edge connection line 136 near the second edge 140 passes through the break in the first connection line 105 to connect to the second connection line 106 adjacent to the first connection line 105.

Continuing to refer to FIG. 1 to FIG. 3, in some embodiments, along the second direction Y, a distance between the edge connection lines 115 and the second connection lines 106 adjacent to edge connection lines 115 is a first spacing d1, and a distance between the second connection lines 106 adjacent to the edge connection lines 115 and the intermediate connection line 125 adjacent to the second connection lines 106 adjacent to the edge connection lines 115 is a second spacing d2. The first spacing d1 is smaller than the second spacing d2. The first spacing d1 is set to be relatively small, so a length of the connection structure 107 connecting the edge connection lines 115 and the intermediate connection lines 125 adjacent to the edge connection lines 115 can be relatively small. This can reduce a path length for the intermediate connection lines 125 adjacent to the edge connection lines 115 to collect carriers from the edge connection lines 115, thereby improving the collection efficiency of carriers from the edge connection lines 115 by the intermediate connection line 125 adjacent to the edge connection line 115, and thus enhancing the performance of the back contact cell.

In some embodiments, the first spacing d1 is 0.5 mm~1.5 mm, for example, 0.5 mm, 0.7 mm, 0.9 mm, 1 mm, 1.2 mm, or 1.5 mm. The second spacing d2 is 0.7 mm~2.0 mm, for example, 0.7 mm, 0.9 mm, 1 mm, 1.2 mm, 1.5 mm, 1.8 mm, or 2 mm. With the first spacing d1 and the second spacing d2 within the above ranges, it is possible to ensure the collection efficiency of carriers from the edge connection lines 115 by the intermediate connection lines 125 adjacent to the edge connection lines 115, while also avoiding short circuits between the first connection lines 105 and the second connection lines 106 due to the first spacing and the second spacing being too small.

In some embodiments, a width of the connection structure 107 along the first direction X is greater than a width of the first grid lines 103 along the first direction X. The connection structure 107 is used to connect the edge connection lines 115 and the intermediate connection lines 125, and the edge connection lines 115 collects carriers from multiple first grid lines 103 and transmits them to the intermediate connection lines 125 adjacent to the edge connection lines 115 via the connection structure 107. Therefore, the width of the connection structure 107 needs to be set relatively large to facilitate the transmission of carriers collected by the edge connection lines 115 to the intermediate connection lines 125 adjacent to the edge connection lines 115.

In some embodiments, along the first direction X, a distance between the connection structure 107 and the functional portion 116 of the second grid lines 104 adjacent to the connection structure 107 is greater than a distance between the second grid lines 104 and the first grid line 103 adjacent to the second grid lines 104. This arrangement avoids a problem of short circuits between the connection structure 107 and the second grid lines 104 due to the distance between the connection structure 107 and the functional portion 116 of the second grid line 104 adjacent to the connection structure 10 being too small.

In some embodiments, along the first direction X, the distance between the connection structure 107 and the functional portion 116 of the second grid line 104 adjacent to the connection structure 107 is 0.5 mm~1.2 mm, for example, 0.5 mm, 0.7 mm, 0.9 mm, 1 mm, or 1.2 mm.

In some embodiments, along the second direction Y, the length of the first connection portion 123 is 0.5 mm~2 mm, for example, 0.5 mm, 0.7 mm, 0.9 mm, 1 mm, 1.2 mm, 1.5 mm, 1.8 mm, or 2 mm. The length of the first main body portions 113 is 0.5 mm~2 mm, for example, 0.5 mm, 0.7 mm, 0.9 mm, 1 mm, 1.2 mm, 1.5 mm, 1.8 mm, or 2 mm. The length of the second connection portion 124 is 0.5 mm~2 mm, for example, 0.5 mm, 0.7 mm, 0.9 mm, 1 mm, 1.2 mm, 1.5 mm, 1.8 mm, or 2 mm. The length of the second main body portion 114 is 0.5 mm~2 mm, for example, 0.5 mm, 0.7 mm, 0.9 mm, 1 mm, 1.2 mm, 1.5 mm, 1.8 mm, or 2 mm. With lengths of the first connection portion 123, the first main body portions 113, the second connection portion 124, and the second main body portions 114 within the above ranges, it is possible to ensure the carrier collection rate of the first grid lines 103 and the second grid lines 104 while reducing metal recombination caused by an excessive contact area between the first grid lines 103 and the first doped conductive layer 101, and reducing metal recombination caused by the excessive contact area between the second grid lines 104 and the second doped conductive layer 102.

The second connection lines 106 adjacent to the edge connection lines 115 include functional portions 116 and a spacing portion 126. The functional portions 116 are connected to the second grid lines 104. The spacing portion 126 is used to separate adjacent functional portions 116 and provide connection space for the connection structure 107 to connect the edge connection lines 115 and the intermediate connection lines 125 adjacent to the edge connection lines 115.

In some embodiments, the functional portions 116 are connected to 6~10 first grid lines 103. For example, the functional portions 116 are connected to 6, 7, 8, 9, or 10 first grid lines 103. Thus, the number of first grid lines 103 connected to the functional portions 116 is moderate. This can avoid dense connection points between the functional portions 116 and the first grid lines 103 that may weaken a mechanical strength of the back contact cell if the functional portions 116 are connected to too many first grid lines 103. It can also avoid weak carrier collection performance of the functional portions 116 if the functional portions 116 are connected to too few first grid lines 103.

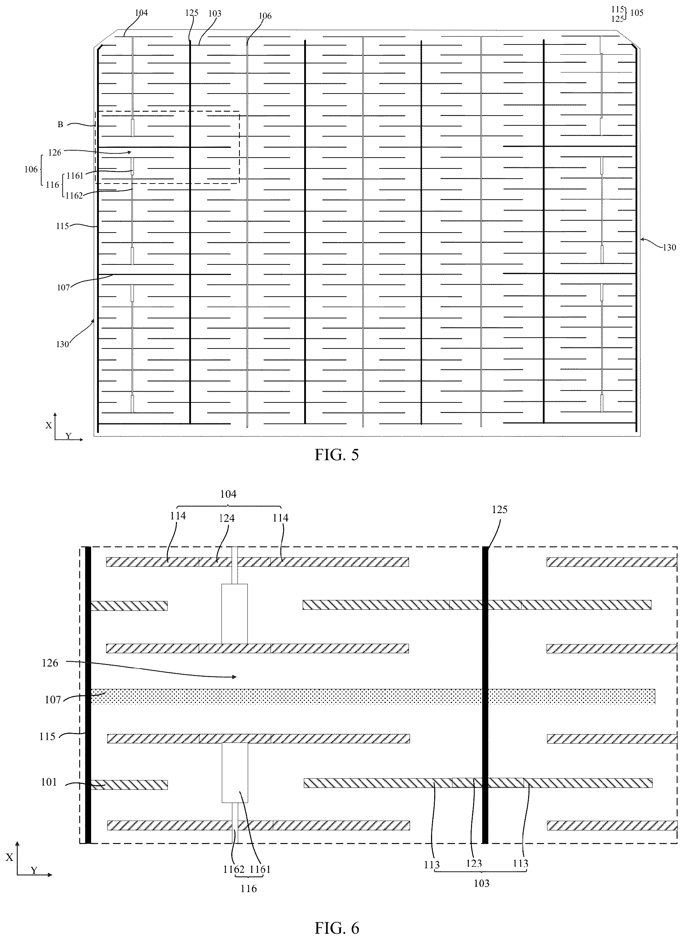

FIG. 5 is a third schematic structural diagram of a back contact cell provided by an embodiment of the present disclosure; FIG. 6 is a partial enlarged schematic view of portion B in FIG. 5.

Referring collectively to FIG. 1, FIG. 5, and FIG. 6, in some embodiments, the functional portions 116 include a first part 1161 adjacent to the connection structure 107 and a second part 1162 connected to the first part 1161. Along the second direction Y, a width of the first part 1161 is greater than a width of the second part 1162. The width of the first part 1161 is set larger to increase a contact area between the second connection lines 106 and the ribbons, improving a welding pull force between the ribbons and the back contact cell. This can avoid problems such as virtual soldering or poor soldering quality between the back contact cell and the ribbons, thereby improving the yield rate of the photovoltaic module.

In some embodiments, along the second direction Y, the width of the first part 1161 is 0.02 mm~0.1 mm, for example, 0.02 mm, 0.03 mm, 0.04 mm, 0.05 mm, 0.06 mm, 0.07 mm, 0.08 mm, or 0.1 mm. The width of the second part 1162 is 0.01 mm~0.05 mm, for example, 0.01 mm, 0.02 mm, 0.03 mm, 0.04 mm, or 0.05 mm. With widths of the first part 1161 and the second part 1162 within the above ranges, it is possible to ensure the soldering quality of the ribbons while avoiding wasted manufacturing costs for the first part 1161 and the second part 1162 if widths of the first part 1161 and the second part 1162 are set too wide.

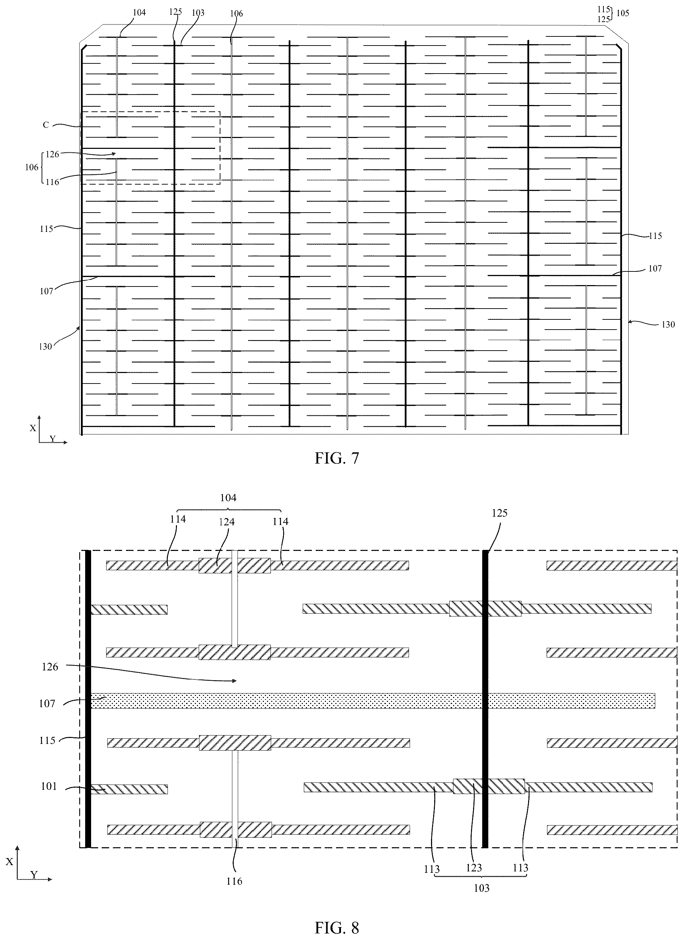

FIG. 7 is a fourth schematic structural diagram of a back contact cell provided by an embodiment of the present disclosure; FIG. 8 is a partial enlarged schematic view of portion C in FIG. 7.

Referring collectively to FIG. 1, FIG. 7, and FIG. 8, in some embodiments, the first connection portion 123 is electrically connected to the first connection lines 105, and the second connection portion 124 is electrically connected to the second connection lines 106. Along the first direction X, the width of the first connection portion 123 is greater than the width of the first main body portions 113, and the width of the second connection portion 124 is greater than the width of the second main body portions 114.

The first connection portion 123 is electrically connected to the first connection lines 105. The width of the first connection portion 123 is set larger to increase the contact area between the first connection portion 123 and the first connection lines 105, thereby improving a rate at which the first connection lines 105 collect carriers from the first grid lines 103, and thus enhancing the performance of the back contact cell. Additionally, setting the width of the first connection portion 123 larger allows for not using a pad; instead, a wider first connection portion 123 can serve as a contact part between the back contact cell and the ribbons to achieve electrical connection between the back contact cell and the ribbons. This can save the material usage for pads and reduce process steps for forming pads, thereby saving a manufacturing cost of the photovoltaic module and improving a manufacturing efficiency of the photovoltaic module.

Similarly, the first connection portion 123 is electrically connected to the second connection line 106. The width of the second connection portion 124 is set larger to increase the contact area between the second connection portion 124 and the second connection line 106, thereby improving the rate at which the second connection line 106 collects carriers from the second grid line 104, and thus enhancing the performance of the back contact cell. Additionally, setting the width of the second connection portion 124 larger allows for not using a pad; instead, the wider second connection portion 124 can serve as the connection part between the back contact cell and the ribbon to achieve electrical connection between the back contact cell and the ribbon. This can save the material usage for pads and reduce the process steps for forming pads, thereby saving the manufacturing cost of the photovoltaic module and improving the manufacturing efficiency of the photovoltaic module.

In some embodiments, along the first direction X, the width of the first connection portion 123 is 0.02 mm~0.1 mm, for example, 0.02 mm, 0.03 mm, 0.04 mm, 0.05 mm, 0.06 mm, 0.07 mm, 0.08 mm, or 0.1 mm. The width of the first main body portions 113 is 0.01 mm~0.05 mm, for example, 0.01 mm, 0.02 mm, 0.03 mm, 0.04 mm, or 0.05 mm. The width of the second connection portion 124 is 0.02 mm~0.1 mm, for example, 0.02 mm, 0.03 mm, 0.04 mm, 0.05 mm, 0.06 mm, 0.07 mm, 0.08 mm, or 0.1 mm. The width of the second main body portions 114 is 0.01 mm~0.05 mm, for example, 0.01 mm, 0.02 mm, 0.03 mm, 0.04 mm, or 0.05 mm. With widths of the first connection portion 123, the first main body portions 113, the second connection portion 124, and the second main body portions 114 within the above ranges, it is possible to improve a rate at which the first connection lines 105 collect carriers from the first grid lines 103 while avoiding resource waste if the widths of the first connection portion 123, the first main body portions 113, the second connection portion 124, and the second main body portions 114 are set too wide.

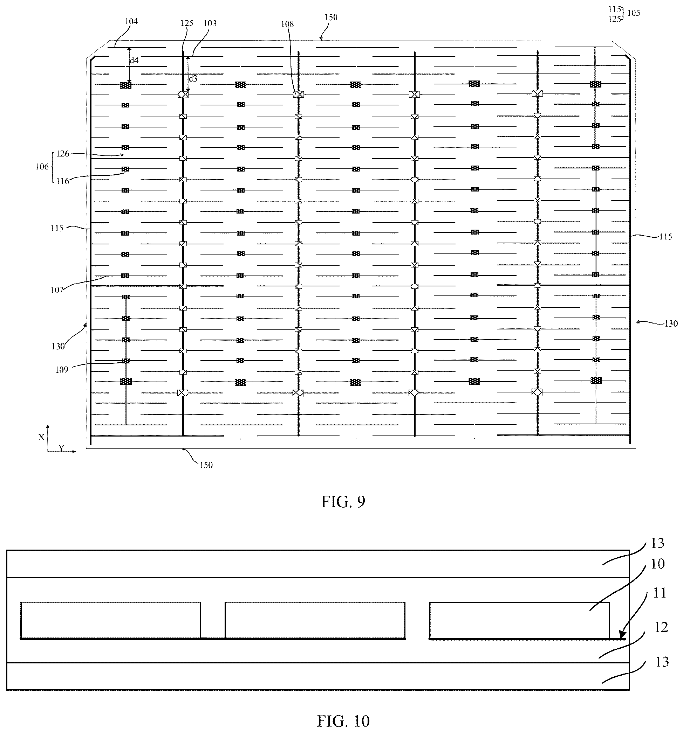

FIG. 9 is a fifth schematic structural diagram of a back contact cell provided by an embodiment of the present disclosure.

It should be noted that, exemplarily, shapes of the first pads 108 and the second pads 109 in FIG. 9 are rectangular. In practice, shapes of the first pads can also be triangular, circular, polygonal, I-shaped, or other shapes, and shapes of the second pads can also be triangular, circular, polygonal, I-shaped, or other shapes.

In some embodiments, the back contact cell further includes: first pads 108, the first pads 108 are located at a junction of a portion of the first connection lines 105 and the first grid lines 103, and are electrically connected to the first connection lines 105 and the first grid lines 103; second pads 109, the second pads 109 are located at a junction of a portion of the second connection lines 106 and the second grid line 104, and are electrically connected to the second connection lines 106 and the second grid lines 104; the second surface 120 further includes a third edge 150 connected to the first edge 130; along the first direction X, the first pads 108 adjacent to the third edge 150 are spaced apart from the first grid lines 103 adjacent to the third edge 150, and the second pads 109 adjacent to the third edge 150 are spaced apart from the first grid lines 103 adjacent to the third edge 150. That is, no pads are provided on the first grid lines 103 and the second grid lines 104 near the third edge 150, which can avoid the problem of cracking or micro-cracking at the back contact cell near the third edge 150 due to soldering stress, thereby improving the yield rate of the photovoltaic module.

In some embodiments, a distance d3 between the first pads 108 adjacent to the third edge 150 and the first grid lines 103 adjacent to the third edge 150 is 5 mm~15 mm, for example, 5 mm, 7 mm, 9 mm, 11 mm, 13 mm, or 15 mm. A distance d4 between the second pads 109 adjacent to the third edge 150 and the first grid lines 103 adjacent to the third edge 150 is 5 mm~15 mm, for example, 5 mm, 7 mm, 9 mm, 11 mm, 13 mm, or 15 mm. With distances within the above ranges, it is possible to avoid the problem of cracking or micro-cracking at the back contact cell near the third edge 150 due to soldering stress, while ensuring that the first pads 108 and the second pads 109 provide sufficient connection force for connecting the back contact cell and the ribbons.

In some embodiments, areas of the first pads 108 near the third edge 150 are larger than areas of the first pads 108 far from the third edge 150; and along the thickness direction of the substrate 100, areas of the second pad 109 near the third edge 150 are larger than areas of the second pad 109 far from the third edge 150. This arrangement increases the contact area between the first pads 108, the second pads 109 and the ribbons, ensuring the soldering quality between the back contact cell and the ribbons.

A thickness direction of the substrate 100 refers to a direction from the first surface 110 to the second surface 120. The areas of the first pads 108 are the contact area between the first pads 108 and the passivation layer on the substrate 100. The areas of the second pads 109 are the contact area between the second pads 109 and the passivation layer on the substrate 100.

In the above-described back contact cell, the connection structure 107 has a first end electrically connected to an edge connection line 115, the connection structure extends from the first end in the second direction and passing through a space between two adjacent functional portions to be electrically connected to the intermediate connection lines 125 adjacent to the edge connection line 115. Through the connection structure 107, the intermediate connection lines 125 adjacent to the edge connections collect the current collected by the edge connection lines 115, thereby allowing the edge connection lines 115 to have no welding portion. This can avoid the problem of cracking or micro-cracking at the edge of the back contact cell due to soldering stress, thus improving the yield rate of the photovoltaic module.

On one hand, a first grid line of the respective set of the first grid lines 103 comprises two first main body portions 113 and a first connection portion 123 between and connecting the two first main body portions 113, and the first connection portion 123 is not in electrical contact with the first doped conductive layer 101, resulting in a smaller contact area between the first grid lines 103 and the first doped conductive layer 101, thereby reducing metal recombination between the first grid lines 103 and the first doped conductive layer 101. On the other hand, a second grid line of the second grid lines 104 comprises two second main body portions 114 and a second connection portion 124 between and connecting the two second main body portions 114, and the second connection portion 124 is not in electrical contact with the second doped conductive layer 102, resulting in a smaller contact area between the second grid lines 104 and the second doped conductive layer 102, thereby reducing metal recombination between the second grid lines 104 and the second doped conductive layer 102. Both aspects are beneficial for improving the performance of the back contact cell.

The embodiments of the present disclosure also provide a photovoltaic module. The photovoltaic module includes a plurality of back contact cells as described in any of the preceding embodiments connected together. The photovoltaic module is used to convert received light energy into electrical energy. It should be noted that parts that are the same as or correspond to the preceding embodiments can be referred to the corresponding descriptions in the preceding embodiments, and will not be repeated below.

FIG. 10 is a cross-sectional structural diagram of a photovoltaic module provided by an embodiment of the present disclosure.

Referring to FIG. 10, the photovoltaic module includes: a cell string, formed by connecting a plurality of the back contact cells 10 described in any of the preceding embodiments; ribbons 11, the ribbons 11 are used to connect adjacent back contact cells 10; an encapsulant film 12, used to cover a surface of the cell string; a cover plate 13, used to cover a surface of the encapsulant film 12 opposite to the cell string.

In some embodiments, the back contact cell 10 can also be an IBC (Interdigitated Back Contact) cell, an HPBC (Hybrid Passivated Back Contact) cell, a TBC cell combining TOPCon technology and IBC technology, or an HBC (Hybrid Back Contact) cell combining HIT/HJT (Heterojunction Technology) technology and IBC technology. Of course, it can also be other types of back contact cells.

In some embodiments, the back contact cell 10 can be a full-size cell or a sliced cell. A sliced cell refers to a cell formed by cutting a complete full-size cell. The back contact cells 10 are electrically connected in the form of full-size or multiple segments to form multiple cell strings. The multiple cell strings are electrically connected in series and/or parallel.

The ribbons 11 are used to connect adjacent back contact cells 10 and transmit the current collected on the back contact cell 10 connected to the ribbons 11 to the module terminal connected to the cell string. One end of the ribbons 11 is electrically connected to the first grid lines of one back contact cell 10, and the other end of the ribbons 11 is electrically connected to the second grid line of the adjacent back contact cell 10.

In some embodiments, the encapsulant film 12 includes a first encapsulation layer and a second encapsulation layer. The first encapsulation layer covers one of the front or back of the back contact cell 10, and the second encapsulation layer covers the other of the front or back of the back contact cell 10. Specifically, at least one of the first encapsulation layer or the second encapsulation layer can be an organic encapsulant film such as Polyvinyl Butyral (PVB) film, Ethylene-Vinyl Acetate Copolymer (EVA) film, Polyolefin Elastomer (POE) film, or Polyethylene Terephthalate (PET) film. Alternatively, at least one of the first encapsulation layer or the second encapsulation layer can also be an EP film, an EPE film, or a PVP film, and the like.

Here, EP film refers to a co-extruded film composed of a laminated EVA film and POE film. EPE film refers to a co-extruded film formed by sequentially laminating EVA film, POE film, and EVA film. PVP film refers to a co-extruded film formed by laminating POE film, and EVA film, and POE film. The manufacturing method of co-extruded films can be extruding one or more raw materials onto another already manufactured film during the film processing, or bonding different types of already manufactured films together.

In some cases, there is still a boundary between the first encapsulation layer and the second encapsulation layer before lamination. After the lamination process to form the photovoltaic module, concepts of the first encapsulation layer and the second encapsulation layer no longer exist; that is, the first encapsulation layer and the second encapsulation layer have already formed an integral encapsulant film.

In some embodiments, the cover plate 13 can be a glass cover plate, a plastic cover plate, or other cover plates with light-transmitting function. Specifically, the surface of the cover plate facing the encapsulant film can be a concave-convex surface or a textured surface containing multiple protrusions to increase the utilization of incident light. The cover plate 13 includes a first cover plate and a second cover plate. The first cover plate is opposite to the first encapsulation layer, and the second cover plate is opposite to the second encapsulation layer.

Those of ordinary skill in the art can understand that the above embodiments are specific embodiments for implementing the present disclosure. In practical applications, various changes can be made in form and details without departing from the scope of the present disclosure. Any person skilled in the art can make various changes and modifications without departing from the scope of the present disclosure. Therefore, the protection scope of the present disclosure shall be defined by the claims.

## Claims

1. A back contact cell (10), comprising:
a substrate (100), the substrate (100) having a first surface (110) and a second surface (120) opposite to each other, the second surface (120) having a first edge (130);
a first doped conductive layer (101) and a second doped conductive layer (102), portions of the first doped conductive layer (101) and portions of the second doped conductive layer (102) being alternately distributed across the second surface (120), doping elements in the first doped conductive layer (101) being of a first conductivity type and doping elements in the second doped conductive layer (102) being of a second conductivity type that is different from the first conductivity types;
first grid lines (103) and second grid lines (104) alternately arranged along a first direction (X), at least a portion of the first grid lines (103) being in electrical contact with the first doped conductive layer (101), at least a portion of the second grid lines (104) being in electrical contact with the second doped conductive layer (102);
first connection lines (105) and second connection lines (106) alternately arranged along a second direction (Y), a respective first connection line of the first connection lines (105) being electrically connected to a respective set of the first grid lines (103), the first connection lines (105) comprising edge connection lines (115) and intermediate connection lines (125), the edge connection lines (115) having no welding portions provided thereon, the second connection lines (106) including a second connection line adjacent to the edge connection lines (115) and comprising a plurality of functional portions (116) spaced apart from each other in the first direction (X), a respective functional portion of the plurality of functional portions (116) being connected to a respective set of a plurality of sets of the second grid lines (104);
a connection structure (107) having a first end electrically connected to an edge connection line, the connection structure (107) extending from the first end in the second direction (Y) and passing through a space between two adjacent functional portions (116) to be electrically connected to the intermediate connection lines (125) adjacent to the edge connection lines (115).

2. The back contact cell according to claim 1, wherein, a first grid line of the respective set of the first grid lines (103) comprises two first main body portions (113) and a first connection portion (123) between and connecting the two first main body portions (113), the first connection portion (123) not being in electrical contact with the first doped conductive layer (101); a second grid line of the second grid lines (104) comprises two second main body portions (114) and a second connection portion (124) between and connecting the two second main body portions (114), the second connection portion (124) not being in electrical contact with the second doped conductive layer (102).

3. The back contact cell according to claim 1 or 2, wherein the functional portion comprises a first part (1161) adjacent to the connection structure (107) and a second part (1162) connected to the first part (1161); along the second direction (Y), a width of the first part (1161) is greater than a width of the second part (1162).

4. The back contact cell according to claim 3, wherein, along the second direction (Y), the width of the first part (1161) ranges from 0.02 mm to 0.1 mm, and the width of the second part (1162) ranges from 0.01 mm to 0.05 mm.

5. The back contact cell according to any one of claims 1 to 4, wherein the first connection portion (123) is electrically connected to the first connection lines (105), the second connection portion (124) is electrically connected to the second connection lines (106), and along the first direction (X), a width of the first connection portion (123) is greater than a width of the first main body portion, and a width of the second connection portion (124) is greater than a width of the second main body portion.

6. The back contact cell according to claim 5, wherein, along the first direction (X), the width of the first connection portion (123) ranges from 0.02 mm to 0.1 mm, the width of the first main body portion ranges from 0.01 mm to 0.05 mm, the width of the second connection portion (124) ranges from 0.02 mm to 0.1 mm, and the width of the second main body portion ranges from 0.01 mm to 0.05 mm.

7. The back contact cell according to any one of claims 1 to 6, wherein, along the second direction (Y), a distance between the edge connection lines (115) and the second connection lines (106) adjacent to the edge connection lines (115) is a first spacing (d1), and a distance between the second connection lines (106) adjacent to the edge connection lines (115) and the intermediate connection lines (125) which is adjacent to the second connection lines (106) adjacent to the edge connection lines (115) is a second spacing (d2), the first spacing (d1) being less than the second spacing (d2).

8. The back contact cell according to claim 7, wherein the first spacing (d1) ranges from 0.5 mm to 1.5 mm.

9. The back contact cell according to claim 7, wherein the second spacing (d2) ranges from 0.7 mm to 2.0 mm.

10. The back contact cell according to any one of claims 1 to 9, wherein the back contact cell further comprises:
first pads (108), the first pads (108) located at an intersection of a portion of the first connection lines (105) and the first grid lines (103), and electrically connected to the first connection lines (105) and the first grid lines (103); and
second pads (109), the second pads (109) located at an intersection of a portion of the second connection lines (106) and the second grid lines (104), and electrically connected to the second connection lines (106) and the second grid lines (104).

11. The back contact cell according to claim 10, wherein
the second surface (120) further comprises a third edge (150) connected to the first edge (130), along the first direction (X), the first pads (108) adjacent to the third edge (150) are spaced apart from the first grid lines (103) adjacent to the third edge (150), and the second pads (109) adjacent to the third edge (150) are spaced apart from the first grid lines (103) adjacent to the third edge (150).

12. The back contact cell according to claim 10, wherein, along the first direction (X), a distance between the first pads (108) adjacent to the third edge (150) and the first grid lines (103) adjacent to the third edge (150) ranges from 5 mm to 15 mm, and a distance between the second pads (109) adjacent to the third edge (150) and the first grid lines (103) adjacent to the third edge (150) ranges from 5 mm to 15 mm.

13. The back contact cell according to any one of claims 1 to 12, wherein a width of the connection structure (107) along the first direction (X) is greater than a width of the first grid lines (103) along the first direction (X).

14. The back contact cell according to any one of claims 1 to 13, wherein the functional portions (116) are connected to 6 to 10 first grid lines (103).

15. A photovoltaic module, comprising:
a cell string, formed by connecting a plurality of back contact cells, each of the plurality of back contact cells being the back contact cell (10) according to any one of claims 1 to 14;
ribbons (11), the ribbon used for connecting adjacent back contact cells;
an encapsulant film (12), used for covering a surface of the cell string; and
a cover plate (13), used for covering a surface of the encapsulant film opposite to the cell string.
